Europäisches Patentamt

European Patent Office

Office européen des brevets

(19)

(11) Veröffentlichungsnummer: **0 253 203 B1**

(12) **EUROPÄISCHE PATENTSCHRIFT**

(45) Veröffentlichungstag der Patentschrift: **18.09.91**

(51) Int. Cl.⁵: **H05K 9/00**

(21) Anmeldenummer: **87109417.3**

(22) Anmeldetag: **30.06.87**

(54) **Kontaktvorrichtung zwischen gegeneinander beweglichen Gehäuseteilen von hochfrequenzdicht abgeschirmten Kabinen oder Räumen.**

(30) Priorität: **17.07.86 DE 3624204**

(43) Veröffentlichungstag der Anmeldung:
**20.01.88 Patentblatt 88/03**

(45) Bekanntmachung des Hinweises auf die
Patenterteilung:
**18.09.91 Patentblatt 91/38**

(84) Benannte Vertragsstaaten:
**AT BE CH DE FR GB IT LI NL**

(56) Entgegenhaltungen:
**EP-A- 0 095 743**
**DE-B- 1 209 171**
**DE-B- 2 451 192**

(73) Patentinhaber: **Siemens Aktiengesellschaft**
**Wittelsbacherplatz 2**
**W-8000 München 2(DE)**

(72) Erfinder: **Schaller, Rudolf, Dipl.-Ing.(FH)**
**Südring 17**
**W-8401 Alteglofsheim(DE)**
Erfinder: **Bienia, Richard, Ing.grad.**
**Sudetenweg 5**
**W-8411 Wenzenbach(DE)**

## Beschreibung

Die Erfindung betrifft eine Kontaktvorrichtung zwischen gegeneinander beweglichen Gehäuseteilen von hochfrequenzdicht abgeschirmten Kabinen oder Räumen, nämlich zwischen Türzargen und Türblättern bzw. Fensterzargen und Fensterflügeln.

In der Fernmelde- und Hochfrequenztechnik ist es wichtig, die Ausbreitung elektrischer und magnetischer Felder in bestimmte Raumbereiche zu verhindern, in denen sie störende Wirkungen ausüben können. Es ist daher häufig erforderlich, einzelne elektrische, elektronische und nachrichtentechnische Geräte und Anlagen, z.B. Rundfunkempfänger oder empfindliche Meßgeräte, vor elektrischen Störeinflüssen durch Einbau in abschirmende Gehäuse oder Käfige zu schützen oder auch ganze Räume abschirmsicher auszustatten. Elektrostatische Felder können schon durch dünne Metallfolien vollkommen abgeschirmt werden, während magnetostatische Felder in Räumen mit Wänden aus ferromagnetischen Materialien abgeschwächt werden.

Da die Abschirmung an Kontaktstellen zwischen festen und beweglichen Raumabschirmungen, z.B. zwischen Fensterzargen und Fensterflügeln bzw. zwischen Türzargen und Türblättern geringer ist als an lückenlosen Wandfeldern, stellen diese Kontaktstellen im allgemeinen die dämpfungsärmsten Bereiche dar. Es besteht daher immer wieder die Forderung, diese Kontaktbereiche den jeweiligen Gegebenheiten anzupassen und die Abschirmung zu verbessern, was z.B. durch speziell hierfür entwickelte Kontaktfedersysteme geschieht. Diese Kontaktierungen erfüllen jedoch nur bedingt die Idealforderungen hinsichtlich Abschirmung und müssen folglich ständig an den technischen Stand der Raumabschirmung angepaßt werden.

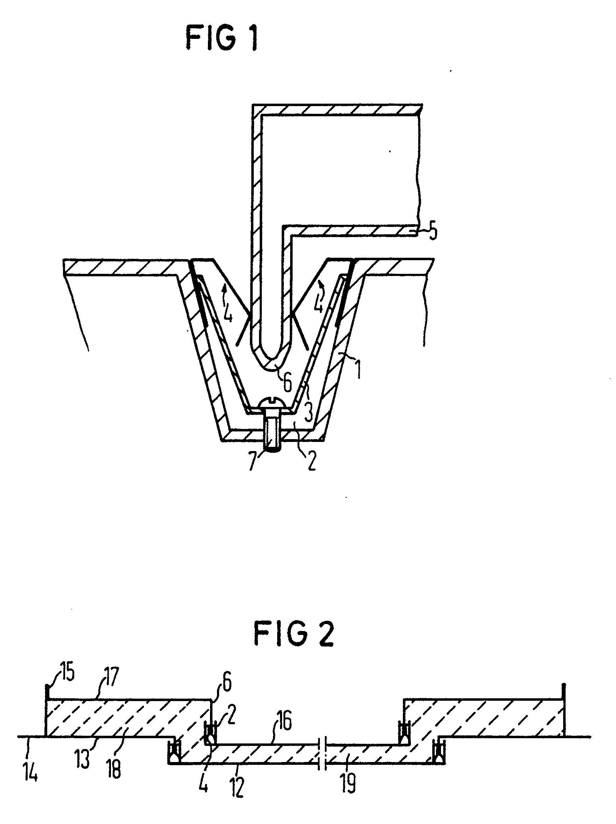

Eine Kontaktvorrichtung ist z.B. in der DE-AS 2451 192 beschrieben und in Fig. 1 in geschnittener und gebrochener Ansicht dargestellt. Eine am einen Gehäuseteil 1 befindliche Nut 2 ist dabei zum Boden hin v-förmig verjüngt und dort abgeflacht. In diese Nut ist eine ebenso v-förmig gebogene, einen größeren Öffnungswinkel aufweisende Schiene 3 eingelegt, die mittels Schrauben 7 mit dem Gehäuseteil 1 verschraubt ist. Die Schiene 3 klemmt auf jeder Seite der Nutöffnung je eine teilweise gefiederte, mechanisch abgewinkelte Blattfeder 4 als Kontaktfeder fest, in die ein am anderen Gehäuseteil 5 angeordneter messerartiger Fortsatz 6 eintaucht, der keilförmig auslaufend gestaltet ist.

An Stelle dieser sogenannten "Messerkontakte" gelangen auch Federsysteme, wie beispielsweise Z-Federn und geteilte Federn zum Einsatz, wie sie im Siemens - Datenbuch 1983/84, "EMV"-Raumschirmung, Kabinen, Bauteile, Filter", Seite 28, gezeigt sind.

In der Europäischen Patentanmeldung EP-A 0095 743 ist in Fig. 1 ebenfalls eine Kontaktvorrichtung gezeigt, die der o.g. ähnlich ist, jedoch zwei Messerkontakt-Systeme mit vier Federreihen in Parallel-Schaltung verwendet. Diese Parallel-Schaltung von Messerkontaktsystemen erhöht zwar gleichfalls die Dämpfung, jedoch nur um wenige Dezibel, da sich nur die Kontaktwiderstände parallel schalten und sich somit nur der Gesamt-Kontaktwiderstand auf etwa die Hälfte gegenüber dem in der DE-AS 245 1192 beschriebenen Kontaktsystem verringert.

Aus der DE-B-1 209 171 ist eine Anordnung zur Abschirmung von Räumen gegen elektromagnetische Felder, insbesondere relativ tiefer Frequenzen (etwa 1 MHz und darunter) an Fenster-, Tür- oder dgl. Wanddurchbrechungen bekannt, bei der die Fugen zwischen der Abschirmwand und dem Fenster-, Tür- oder dgl. Wandeinsätzen durch elektrische Kontaktmittel, z.B. Mehrfachkontakfederbleche abgedichtet sind. Die bekannte Anordnung besitzt mindestens eine zusätzliche Schirmhülle in Abstand von dem Wandeinsatz der Abschirmwand und von einem den Fugen benachbarten Teil der Abschirmwand, die elektromagnetisch dicht mit der Abschirmwand kontaktiert ist. Diese Schirmhülle weist ebenfalls eine entsprechende Durchbrechung und einen Einsatz mit die Fugen abdichtenden elektrischen Kontaktmitteln auf, wobei der Wandeinsatz der Abschirmwand mit dem Einsatz der Schirmhülle elektrisch lediglich auf dem Umweg über die elektrischen Kontaktmittel der Fugen in der Abschirmwand, die Kontaktierungsstellen der Schirmhülle mit der Abschirmwand und schließlich die elektrischen Kontaktmittel der Fugen in der Schirmhülle kontaktiert ist.

Der vorliegenden Erfindung liegt die Aufgabe zugrunde, eine Kontaktvorrichtung der eingangs genannten Art zu schaffen, die insbesondere im tiefen Frequenzbereich von einigen kHz die Dämpfung der Türen und Fenster erheblich verbessert.

Diese Aufgabe wird erfindungsgemäß dadurch gelöst, daß die Türzargen und Türblätter bzw. Fensterzargen und Fensterflügel zweischalig und zwischen ihren Schalen bevorzugt mit magnetischem Füllmaterial gefüllt sind, und daß in Schließstellung der Türen und Fenster jeweils die zueinander gekehrten Stirnenden der inneren Schalen der Türzargen und Türblätter bzw. der Fensterzargen und Fensterflügel und jeweils die zueinander gekehrten Stirnenden der äußeren Schalen der Türzargen und Türblätter bzw. der Fensterzargen und Fensterflügel miteinander kontaktiert sind, wobei als diese Kontaktierungen Kontaktfedersysteme vorgesehen sind.

Diese Kontaktvorrichtung benutzt zwar gleichfalls die bekannten Kontaktfedersysteme, doch handelt es sich hierbei nicht um eine reine Parallel-Schaltung der Systeme, sondern durch die Doppelwandigkeit des Türblattes und der Türzarge bzw. des Fensterflügels und der Fensterzarge und der damit hervorgerufenen Induktivität des Zwischenraumes ergibt sich eine vorteilhafte elektrische Entkoppelung der Kontakt-Systeme untereinander und somit ähnlich wie bei einem π-Filter eine höhere Dämpfung.

Messungen, die gemäß der Vorschrift MIL STD 285 durchgeführt wurden, ergaben bei Verwendung eines Messerkontaktsystems Dämpfungswerte für das magnetische Nahfeld von weit über 100 Dezibel bei 10 kHz und damit Werte die erheblich höher liegen als die für bekannte Konstruktionen gemessenen Werte, die etwa 70 Dezibel betragen.

In der Zeichnung ist in teils gebrochener und geschnittener Ansicht eine Kontaktvorrichtung nach der Erfindung für eine Türe dargestellt.

Das Türblatt und die Türzarge sind dabei zweischalig, nämlich mit Schalen 12,16 bzw. 13,17 ausgeführt. Zur Erhöhung der Hohlrauminduktivität sind die Räume zwischen den Schalen 12,16 bzw. 13,17 jeweils mit magnetischem, von den Schalen elektrisch isoliertem Material 19 bzw. 18 gefüllt, so daß zwischen der äußeren und der inneren Schale des Türblattes bzw. der Türzarge im wesentlichen keine elektrische Verbindung besteht. Eine solche ist bei der in der Zeichnung dargestellten zweischaligen Türzarge nur am äußeren Rand vorhanden, nämlich eine geschweißte Bördel naht 15, die wiederum mit der Raumschirmung 14 elektrisch und hochfrequenzdicht, z.B. durch Schweißung verbunden ist.

Die inneren und äußeren Schalen der Türzarge bzw. des Türblattes sind mit ihren zueinander gekehrten Stirnenden jeweils über Messerkontaktsysteme 2,4,6 elektrisch und hochfrequenzdicht miteinander kontaktiert. Mit 2 ist dabei jeweils eine an der inneren und äußeren Schale 16 bzw. 12 des Türblattes angeordnete Nut bezeichnet, die Kontaktfedern 4 enthält, in welche messerartige Fortsätze 6 der inneren und äußeren Schalen der Türzarge eintauchen.

Die Erfindung ist nicht auf das vorstehend erläuterte und in der Zeichnung dargestellte Kontaktfeder-System beschränkt. Denkbar sind auch die bereits erwähnten, z.B. im genannten Siemens-Datenbuch beschriebenen Z-Federsysteme und geteilte Federsysteme.

Bezugszeichenliste

1 -      Gehäuseteil
2 -      Nut
3 -      Schiene
4 -      Kontaktfeder
6 -      messerartiger Fortsatz

7 -      Schraubbolzen
12 -    äußere Schale des Türblattes
13 -    äußere Schale der Türzarge
14 -    Raumschirmung
15 -    Bördelnaht
16 -    innere Schale des Türblattes Fertigungslinie
17 -    innere Schale der Türzarge

Patentansprüche

1. Kontaktvorrichtung zwischen gegeneinander beweglichen Gehäuseteilen von hochfrequenzdicht abgeschirmten Kabinen oder Räumen, nämlich zwischen Türzargen und Türblättern bzw. Fensterzargen und Fensterflügeln, **dadurch gekennzeichnet,** daß die Türzargen und Türblätter bzw. Fensterzargen und Fensterflügel zweischalig sind, und daß in Schließstellung der Türen und Fenster jeweils die zueinander gekehrten Stirnenden der inneren Schalen (17, 16) der Türzargen und Türblätter bzw. der Fensterzargen und Fensterflügel und jeweils die zueinandergekehrten Stirnenden der äußeren Schalen (13, 12) der Türzargen und Türblätter bzw. der Fensterzargen und Fensterflügel miteinander kontaktiert sind, wobei als diese Kontaktierungen Kontaktfedersysteme vorgesehen sind.

2. Kontaktvorrichtung nach Anspruch 1, d.h., daß die Türzargen und Türblätter bzw. Fensterzargen und Fensterfügel zwischen ihren Schalen (12,16; 13,17) mit magnetischem Füllmaterial (18,19) gefüllt sind.

Claims

1. Contact device between housing components, movable with respect to one another, of radio frequency-tight, shielded cabins or spaces, namely between door frames and door leaves or window frames and window leaves, characterised in that the door frames and door leaves or window frames and window leaves are two-shelled, and in that in the closed position of the doors and windows in each case the ends facing each other of the inner shells (17, 16) of the door frames and door leaves or of the window frames and window leaves, and in each case the ends facing one another of the outer shells (13, 12) of the door frames and door leaves or of the window frames and window leaves are in contact with one another, contact spring systems being provided as these contacts.

2. Contacting device according to Claim 1, that is to say that the door frames and door leaves or window frames and window leaves are filled between their shells (12, 16; 13, 17) with magnetic filling material (18, 19).

**Revendications**

1. Dispositif de contact entre des parties réciproquement mobiles d'enceintes de cabines ou de pièces blindées de manière à être étanches aux hautes fréquences, notamment entre des châssis de portes et des ventaux de portes ou des châssis de fenêtres et des battants de fenêtres, et les extrémités frontales, qui se font face, des coques extérieures (13,12) des châssis de portes et des battants de portes ou des châssis de fenêtres et des battants de fenêtres sont respectivement en contact réciproque, des systèmes à ressorts de contact étant prévus pour ces contacts.

2. Dispositif de contact suivant la revendication 1, dans lequel les châssis de portes et les ventaux de portes ou les châssis de fenêtres et les battants de fenêtres sont remplis, entre leurs coques (12,16;13,17), par un matériau de remplissage magnétique (18,19).

# FIG 1

# FIG 2